# EUROPÄISCHE PATENTSCHRIFT

(11) **EP 0 907 453 B1**
(45) Veröffentlichungstag und Bekanntmachung des Hinweises auf die Patenterteilung: **10.11.1999**
(21) Anmeldenummer: 97921822.9
(22) Anmeldetag: 29.04.1997
(51) Int. Cl.: B23K 1/08, H05K 3/34, B23K 37/06

(54) **VERFAHREN ZUM VERLÖTEN VON ELEKTRONISCHEN BAUELEMENTEN AUF EINER LEITERPLATTE**
PROCESS FOR SOLDERING ELECTRONIC COMPONENTS TO A PRINTED CIRCUIT BOARD
PROCEDE POUR BRASER DES COMPOSANTS ELECTRONIQUES SUR UNE CARTE DE CIRCUITS IMPRIMES

(30) Priorität: 07.05.1996 DE 19618227
(43) Veröffentlichungstag der Anmeldung: 14.04.1999
(73) Patentinhaber: Herbert Streckfuss GmbH, 76344 Eggenstein (DE)
(72) Erfinder: STRECKFUSS, Herbert, D-76199 Karlsruhe (DE); LIEDKE, Volker, D-76774 Leimersheim (DE)
(74) Vertreter: Lasch, Hartmut Dipl.-Ing.
(86) Internationale Anmeldenummer: EP9702199
(87) Internationale Veröffentlichungsnummer: WO9741991

(56) Entgegenhaltungen:
- AT-A- 297 827
- US-A- 4 659 002
- US-A- 4 739 919
- PATENT ABSTRACTS OF JAPAN vol. 014, no. 073 (E-0887), 9.Februar 1990 & JP 01 290293 A (MATSUSHITA ELECTRIC IND CO LTD), 22.November 1989,
- PATENT ABSTRACTS OF JAPAN vol. 013, no. 561 (E-859), 13.Dezember 1989 & JP 01 232794 A (MATSUSHITA ELECTRIC IND CO LTD), 18.September 1989,

## Beschreibung

Die Erfindung betrifft ein Verfahren zum Verlöten von weiteren elektronischen Bauelementen auf einer Leiterplatte, die bereits verlötete Bauelemente trägt, wobei die weiteren Bauelemente durch die Leiterplatte hindurchgesteckt und mit dieser verlötet werden.

Um elektronische Bauelemente auf einer Leiterplatte zu verlöten, wurde früher üblicherweise die sogenannte Durchsteckmontage angewendet, bei der dünne Anschlüsse der Bauelemente, sogenannte Beinchen, von einer Seite in Bohrungen der Leiterplatte eingesteckt und auf der Rückseite durch Aufbringen von Lot mit dieser verbunden werden. Dabei wird in der Regel das sogenannte Schwallverfahren angewendet, bei dem das flüssige Lot in Form eines Schwalles auf die Rückseite der Leiterplatte aufgebracht wird. Nachteilig ist bei diesem Verfahren, daß die Leiterplatte dabei nur einseitig bestückt werden kann.

Des weiteren ist die sogenannte Oberflächenmontage entwickelt worden, bei der die Bauelemente auf der Oberfläche der Leiterplatte angeordnet und verlötet werden, ohne die Leiterplatte zu durchdringen. Auf diese Weise ist eine beidseitige Bestückung der Leiterplatte möglich. Auch hierbei kann das Lot in dem Schwallverfahren aufgebracht werden, jedoch wird üblicherweise die sogenannte Reflow-Technik angewandt. Dabei wird Lot in Form einer Lotpaste aufgebracht, die einen Harzanteil enthält und somit gleichzeitig zum Fixieren der anzulötenden Bauelemente dienen kann. Die Bauelemente werden nach dem Aufbringen der Lotpaste in diese eingesetzt und in der durch den Harzanteil fixierten Lage in einen Ofen eingebracht, in dem die Lotpaste bzw. das Lot schmilzt und die Bauelemente mit der Leiterplatte verbunden werden.

In vielen Fällen ist es notwendig, auf eine Leiterplatte, die bereits nach einem der beiden Verfahren aufgebrachte und montierte elektronische Bauelemente trägt, nachträglich weitere elektronische Bauelemente aufzubringen und zu verlöten. Dabei entsteht die Schwierigkeit, daß bei dem nachträglichen Verlöten die bereits auf der Leiterplatte vorhandenen Bauelemente sowie deren Lötverbindungen nicht beschädigt werden dürfen. Die nachträglich zu montierenden Bauelemente werden deshalb durch die Leiterplatte in genannter Weise durchgesteckt und mittels einzelner Lötpunkte und -bereiche mit der Leiterplatte verbunden.

Aus der DE 43 14 241 A1 ist es bekannt, zur Ausbildung von einzelnen Lötpunkten oder -bereichen einen kleinen Lötkopf vorzusehen, an dessen oberem Austrittsende das Lot in Form einer kleinen Welle überfließt, so daß ein sogenannter Minischwall gebildet ist. Es hat sich gezeigt, daß ein derartiger kleiner Lötkopf keine zuverlässigen Lötergebnisse bringt, da das Lot eine hohe Affinität zum Sauerstoff besitzt, so daß sich an der Oberfläche des Lötkopfes häufig Verschmutzungen in Form einer Oxidationsschicht finden, die nicht oder nur schwer zu entfernen sind. Es hat sich des weiteren gezeigt, daß die Schwallhöhe gewissen Schwankungen unterliegt, die die Lötergebnisse beeinträchtigen können. Darüber hinaus stellt sich bei den relativ geringen Lotmengen ein ungleichmäßiger Lotablauf ein.

Die nachträglich auszubildenden Lötpunkte oder -bereiche sind üblicherweise ungleichmäßig über die Leiterplatte verteilt. Dies führt bei dem genannten Verfahren zu dem weiteren Nachteil, daß die Leiterplatte entweder oberhalb des Lötkopfes während des Lötvorgangs verschoben werden muß oder daß eine Vielzahl von Lötköpfen entsprechend der Anzahl der auszubildenden Lötpunkte vorgesehen werden muß. Im ersten Fall ergeben sich sehr komplizierte Bewegungsabläufe, wodurch das Verfahren langsam und uneffektiv und die Vorrichtung konstruktiv aufwendig und teuer wird. Im zweiten Fall ist der konstruktive Aufwand ebenfalls sehr hoch und das Risiko unzulänglicher Lötergebnisse infolge Verschmutzungen ist aufgrund der hohen Ahzahl von Lötköpfen übermäßig groß.

In der US 5 176 312 ist eine Vorrichtung zum Verlöten von elektronischen Bauelementen auf einer Leiterplatte gezeigt, bei der auf der Oberseite des Lotbades eine Düsenplatte befestigt ist, die mehrere unterschiedliche Düsen aufweist, die entsprechend den zu verlötenden Punkten oder Bereichen angeordnet sind und durch die das Lot mittels einer Pumpe auf diese aufgebracht werden kann. Da diese Düsen unterschiedliche Querschnittsformen und Durchmesser besitzen, ergeben sich beim Aufbringen des Lotes in den Düsen unterschiedliche Strömungs- und Druckverhältnisse, die schwierig zu beherrschen sind. Darüber hinaus besteht auch hierbei die Gefahr, daß die Düsen aufgrund ihres teilweise kleinen Durchmessers in oben genannter Weise leicht verschmutzen oder verstopfen und das Lötergebnis beeinträchtigen.

Eine gleichartige Lösung ist in der AT 297 827 beschrieben, bei der am oberen Ende eines das Lotbad bildenden Schachtes ein Lotleitblech mit Durchbrechungen angeordnet ist. Das Lot kann innerhalb des Schachtes mittels einer Fördervorrichtung angehoben werden, so daß es in den Durchbrechungen aufsteigt und an deren Oberseite konvexe Lotkappen bildet. Das Anheben des Lotes in dem Schacht sowie den Durchbrechungen führt zu den vorgenannten Nachteilen bezüglich schwierig zu beherrschender Strömungs- und Druckverhältnisse.

Auch aus der US 4 739 919 ist es bekannt, zusätzliche elektronische Bauelemente auf einer Leiterplatte zu verlöten, die bereits verlötete Bauelemente trägt. Zu deren Schutz ist eine Metallschablone vorgesehen, auf der die Leiterplatte derart angeordnet wird, daß die bereits verlöteten Bauelemente in Ausnehmungen der Metallschablone aufgenommen sind. Auf der Metallschablone durchläuft die Leiterplatte die Lötmaschine, so daß eine Vielzahl von Metallschablonen für den Betrieb der Lötmaschine notwendig sind, was sehr aufwendig und kostenintensiv ist. Die zusätzlichen Bauelemente werden auf der Leiterplatte durch ein Wellenlötverfahren befestigt, in dem eine Lotwelle bzw. ein Lötschwall auf der der Leiterplatte abgewandten Seite der Metallschablone aufgebracht wird und in Durchbrechungen der Metallschablone aufsteigt. Auch hiermit sind die eingangs genannten Nachteile verbunden. Darüber hinaus ist die Verwendung von Metallschablonen bei dem Verfahren gemäß der US 4 739 919 besonders problematisch, da Metalle einen relativ großen Wärmeausdehnungskoeffizienten besitzen. Wenn das Lot mit der Metallschablone in Kontakt kommt, entstehen in der Metallschablone schlagartig örtliche Temperaturerhöhungen, wodurch sich die Metallschablone verformt, so daß eine korrekte Ausrichtung der Leiterplatte nicht mehr sichergestellt ist.

JP-A-01290293 offenbart ein Verfahren gemäß dem Oberbegriff des Anspruchs 1. Dabei bleibt offen, wie das Aufsteigen des Lots in den Durchbrechungen erreicht wird.

Der Erfindung liegt die Aufgabe zugrunde, ein Verfahren der genannten Art zu schaffen, bei welchem das Aufsteigen des Lots in sicherer, gleichmäßiger und genauer Weise erreicht wird.

Diese Aufgabe wird durch ein Verfahren gemäß Anspruch 1 gelöst.

Erfindungsgemäß wird das Lot auf die nachträglich zu verlötenden Punkte oder Bereiche somit nicht durch spezielle Düsen oder einen Minischwall aufgebracht, sondern es ist ein Tauchverfahren vorgesehen, bei dem nur die mit dem Lot zu benetzenden Punkte oder Bereiche der Bauteile bzw. der Leiterplatte in das Lotbad eingetaucht werden. Zu diesem Zweck wird die Schablone auf die Oberfläche des Lotbades abgesenkt, wodurch diejenigen Abschnitte der Lotbadoberfläche, die nicht mit der Leiterplatte in Kontakt treten sollen, abgedeckt werden. Mittels der Schablone werden somit mehrere kleine Lotflächen bereitgestellt, in die die entsprechenden Abschnitt der Leiterplatte bzw. der zu verlötenden Bauelemente eingetaucht werden können. Da die Druckerhöhung im Lotbad nicht mittels einer Pumpe, sondern allein durch das vollflächige Absenken der Schablonen auf die Lotbadoberfläche erreicht wird, läßt sich ein gleichmäßiges Aufsteigen des Lots in den Durchbrechungen der Schablone erzielen.

Die Führung ermöglicht eine sichere und genaue Bewegung der Schablone zwischen der abgesenkten und der abgehobenen Stellung.

Es hat sich bewährt, in einer ersten Ausgestaltung des erfindungsgemäßen Verfahrens zunächst die Schablone auf die Oberfläche des Lotbades abzusenken und auf diese aufzudrücken, wodurch das Lot verdrängt wird und in den Durchbrechungen aufsteigt, so daß eine Vielzahl von Tauchbädern gebildet ist. Anschließend wird dann die Leiterplatte auf die Schablone aufgesetzt, wobei die zu verlötenden Bereiche in die Tauchbäder eintauchen. Alternativ ist es jedoch auch möglich, die Leiterplatte zunächst auf die Schablone aufzusetzen und anschließend zusammen mit dieser auf die Oberfläche des Lotbades abzusenken.

Um die Gefahr von Verunreinigungen infolge einer Oxidationsschicht an der Oberfläche von relativ kleinen Lotbädern auszuschließen, wird die Schablone nach der Leiterplatte oder zusammen mit dieser von dem Lotbad abgehoben, so daß wieder die gesamte Oberfläche des Lotbades zugänglich ist, die in einfacher Weise gereinigt werden kann.

Die Reinigung kann mittels eines Rakels oder durch einen gesteuerten Überlauf erfolgen. Auf diese Weise ist sichergestellt, daß auch die Oberflächen der mittels der Schablone ausgebildeten kleinen Lotbäder von Verunreinigungen weitestgehend frei sind.

Es hat sich gezeigt, daß mit dem erfindungsgemäßen Verfahren hohe Durchsatzraten an Leiterplatten zu erzielen sind, da die einzelnen Lötpunkte oder -bereiche jeweils simultan verlötet werden, ohne daß Querbewegungen der Leiterplatte notwendig sind. Damit ist auch der weitere Vorteil verbunden, daß die Taktzeit nicht von der Anzahl der Lötstellen abhängig ist. Darüber hinaus hat sich das erfindungsgemäße Verfahren als sehr sicher erwiesen, da aufgrund der Stoffeigenschaften des Lotes (Dichte, Viskosität, Fließverhalten) größere Mengen besser zu beherrschen sind als die aus dem Stand der Technik bekannten kleinen Lotmengen.

Wenn die Leiterplatte mit den bereits montierten Bauelementen nach der eingangs erläuterten Durchsteckmontage bestückt wurde, befinden sich die Bauelemente nur auf der dem Lotbad abgewandten Seite der Leiterplatte. Wenn die Bauelemente jedoch mit einer Oberflächenmontage auf beiden Seiten der Leiterplatte angeordnet sind, kann es nötig sein, die auf der dem Lotbad zugewandten Seite der Leiterplatte befindlichen Bauelemente vor dem Lot zu schützen. Zu diesem Zweck ist in Weiterbildung der Erfindung vorgesehen, daß die Schablone auf ihrer der Oberfläche des Lotbades abgewandten Seite Ausnehmungen aufweist, in denen die bereits auf der Leiterplatte montierten Bauelemente während des Lötvorgangs aufgenommen werden. Neben der Schutzwirkung vor dem Lot ist mit diesen Ausnehmungen der weitere Vorteil verbunden, daß die Leiterplatte tiefer auf die Schablone abgesenkt werden kann, wodurch gewährleistet ist, daß die zu verlötenden Punkte oder Bereiche zuverlässig in die kleinen Lotbäder eintauchen. Dabei ergibt sich erfindungsgemäß eine relativ große mögliche Eintauchtiefe, da die Schablone auch die Abdeckung sehr hoher Bauelemente bzw. mechanischer Aufbauten auf der Leiterplatte durch entsprechende Ausnehmungen bzw. eingearbeitete Abdeckkappen ermöglicht.

Als Führung für die Schablone finden beispielsweise zumindest zwei Führungsstifte Verwendung, die am Gehäuse fest angebracht sind und in entsprechende Durchgangsbohrungen der Schablone unter enger Passung eingreifen.

Um Lötverbindungen mit hoher Genauigkeit zu erzielen, sollte die Leiterplatte relativ zu der Schablone mittels einer Führungsvorrichtung geführt und positioniert werden. Vorzugsweise ist dabei die Leiterplatte auf einem Aufnahmerahmen angeordnet, der relativ zur Schablone geführt ist und auf diese abgesenkt bzw. von dieser abgehoben werden kann. Auch die Führung des Aufnahmerahmens relativ zur Schablone kann durch die Führungsstifte erfolgen, die bereits der Führung der Schablone relativ zum Lotbad dienen.

Um das Lotbad für unterschiedliche Baugruppenkonfigurationen einsetzen zu können, ist vorzugsweise vorgesehen, daß die Schablone auswechselbar ist. Auf diese Weise ist eine schnelle und konstruktiv einfache Anpassung an unterschiedliche Muster von auszubildenden Lötpunkten möglich. Ein weiterer Vorteil der auswechselbaren Schablone besteht darin, daß das schwere, beheizte und teure Lotbad nicht umgebaut zu werden braucht, da die Anpassung an unterschiedliche Konfigurationen allein durch den Schablonenwechsel erfolgen kann.

Beim Verlöten von elektronischen Bauelementen ist es üblich, vor dem eigentlichen Lötvorgang auf die zu überwindenden Oberfläche ein Flußmittel aufzubringen, das die Oberfläche-Oxidation verringern oder aufheben soll, um auf diese Weise eine bessere Lötverbindung zu erreichen. Das Flußmittel ist beim nachträglichen Verlöten von Bauelementen nur in den zu verlötenden Punkten oder Bereichen der Leiterplatte aufzubringen. Dies kann erfindungsgemäß in einfacher Weise dadurch erreicht werden, daß das Flußmittel unter Zwischenschaltung einer Sprühschablone aufgesprüht wird, die ebenfalls ein Muster von Durchbrechungen entsprechend den nachträglich auf der Leiterplatte auszubildenden Lötpunkten oder -bereichen aufweist. Auf diese Weise kann sichergestellt werden, daß das Flußmittel nur an den gewünschten Stellen auf die Leiterplatte aufgebracht wird. Der sich üblicherweise auf der Leiterplatte niederschlagende unerwünschte Overspray wird von der Sprühschablone abgefangen.

In bevorzugter Ausgestaltung ist vorgesehen, daß die Leiterplatte oberhalb der Sprühschablone positioniert und das Flußmittel von unten aufgesprüht wird. Anschließend kann die Leiterplatte gegebenenfalls in an sich bekannter Weise vorgewärmt werden.

Weitere Einzelheiten und Merkmale der Erfindung sind aus der folgenden Beschreibung von Ausführungsbeispielen unter Bezugnahme auf die Zeichnung ersichtlich. Es zeigen:
- Figur 1a, 1b, 1c, 1d, 1e und 1f: die einzelnen Phasen einer 1. Ausgestaltung des erfindungsgemäßen Verfahrens,
- Figur 2a, 2b, 2c, 2d, 2e und 2f: die einzelnen Phasen einer 2. Ausgestalung des erfindungsgemäßen Verfahrens und
- Figur 3: eine schematische Darstellung einer Anlage zur Durchführung des Verfahrens.

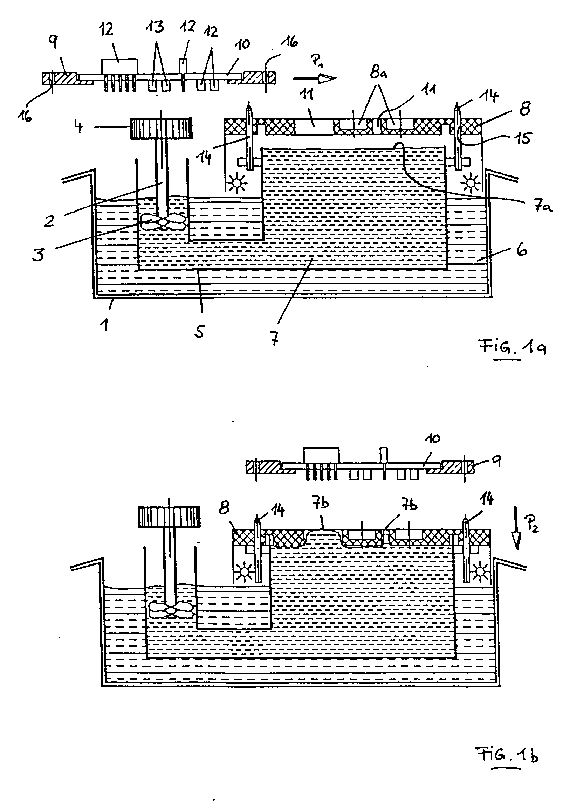

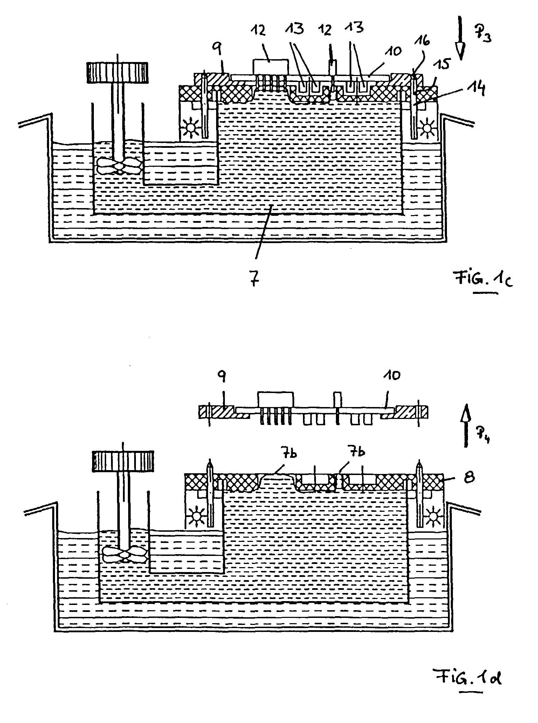

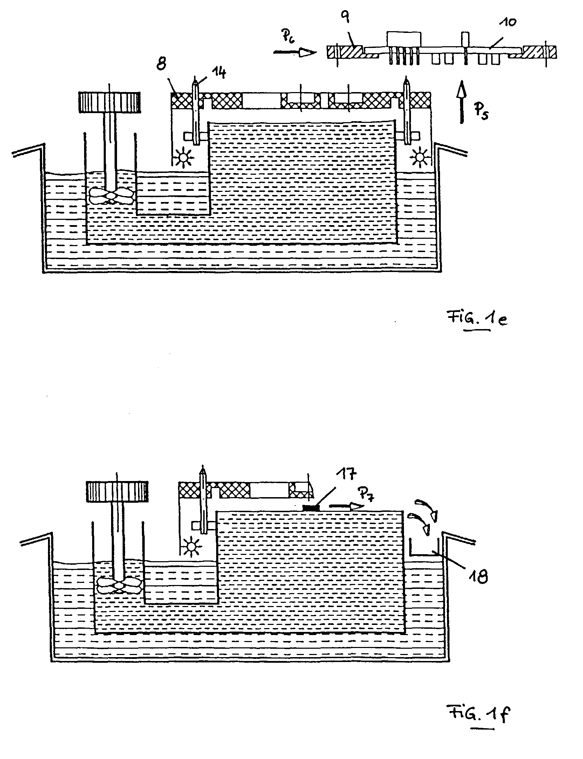

In den Figuren 1a bis 1f sind die einzelnen Phasen einer 1. Ausgestaltung des erfindungsgemäßen Verfahrens dargestellt.

In einem äußeren Behälter 1 befindet sich ein flüssiges Lot 6, in das ein innerer Behälter 5 eingesetzt ist, in den das Lot über nicht dargestellte Zulauföffnungen einströmen kann. Das im inneren Behälter 5 angeordnet Lotbad 7 kann mittels einer Pumpe, die aus einem von einem Elektromotor 4 über eine Antriebswelle 2 angetriebenen Pumpenrad 3 gebildet ist, auf einem vorbestimmten, definierten statischen Druckniveau gehalten werden, so daß die Oberfläche des Lotbades 7 eine vorbestimmte Soll-Position beibehält.

Eine Leiterplatte 10, die einen herkömmlichen Aufbau besitzt, ist bereits mit nach dem Oberflächenverfahren vormontierten und verlöteten Bauelementen 13, sog. SMDs bestückt. Zusätzlich sollen mit dem erläuterten Verfahren auf der Leiterplatte 10 weitere elektronische Bauelemente 12 verlötet werden, die in einem nicht dargestellten Arbeitsschritt durch die Leiterplatte 10 hindurchgesteckt sind, wie in Figur 1a gezeigt ist. Die Leiterplatte 10 ist auf einen Aufnahmerahmen 9 aufgelegt, auf dem sie durch verschiedene Stationen einer Lötmaschine hindurchgeführt wird.

Oberhalb der Oberfläche 7a des in dem inneren Behälter 5 befindlichen Lotbades 7 ist eine Schablone 8 angeordnet, die mehrere Durchbrechungen 11 aufweist. Die Durchbrechungen 11 entsprechen in ihrer Anordnung den nachträglich auf der Leiterplatte 10 auszubildenden Lötpunkten oder -bereichen, um die Bauelemente 12 zu verlöten. Des weiteren besitzt die Schablone 8 auf ihrer dem Lotbad 7 abgewandten und der Leiterplatte 10 zugewandten Oberfläche mehrere Ausnehmungen 8a, in die die bereits auf der Leiterplatte verlöteten Bauelemente 13 während des Lötvorgangs eingeführt werden können. Wie in Figur 1a durch den Pfeil P₁ angedeutet ist, wird der Aufnahmerahmen 9 mit der aufgelegten Leiterplatte 10 zunächst über die Schablone 8 verfahren.

In einem anschließende Verfahrensschritt wird die Schablone 8 aus der in Figur 1a dargestellten Stellung, in der sie oberhalb der Oberfläche 7a des Lotbades 7 angeordnet ist, auf die Oberfläche 7a des Lotbades abgesenkt (Pfeil P₂), bis die Oberfläche 7a des Lotbades 7 abgedeckt ist und das Lot des Lotbades 7 in die Durchbrechungen 11 der Schablone 8 verdrängt wird und in diesen aufsteigt, ohne jedoch diese zu überströmen (Figur 1b). Auf diese Weise sind mehrere kleine Lotbäder 7b gebildet, deren gegenseitige Anordnung dem Muster der auf der Leiterplatte 10 auszubildenden Lötpunkte und -bereiche entspricht. Bei der Absenkbewegung ist die Schablone 8 durch vertikale Führungsstifte 14 geführt, die am inneren Behälter 5 angebracht sind und in entsprechende Durchgangsbohrungen 15 der Schablone 8 unter enger Passung eingreifen.

Anschließend wird der Aufnahmerahmen 9 mit der Leiterplatte 10 auf die Schablone 8 abgesenkt (Pfeil P₃), wobei die die Schablone 8 durchragenden freien Enden der Führungsstifte 14 in entsprechende Bohrungen 16 des Aufnahmerahmens 9 eingreifen, so daß der Aufnahmerahmen 9 und somit auch die darauf befindliche Leiterplatte 10 relativ zur Schablone 8 und relativ zum Lotbad 7 geführt sind. Wie Figur 1c zeigt, treten dabei die bereits fertig verlöteten Bauteile 13 in die Ausnehmungen 8a der Schablone 8 ein und sind auf diese Weise geschützt. Die nach unten vorstehenden Kontakte bzw. Beinchen der zu verlötenden Bauteile 12 tauchen in die kleinen Lotbäder 7b ein, die in den Durchbrechungen 11 der Schablone 8 gebildet sind. In dieser Stellung verbleibt der Aufnahmerahmen 9 mit der Leiterplatte 10 für etwa 2 bis 3 Sekunden.

In daran anschließenden Verfahrensschritten wird zunächst der Aufnahmerahmen 9 mit der Leiterplatte 10 (Pfeil P₄ in Figur 1d) und anschließend auch die Schablone 8 von dem Lotbad 7 abgehoben (Pfeil P₅ in Figur 1e). Der Aufnahmerahmen 9 mit der Leiterplatte 10 wird dann in der Maschine zu einer nächsten Bearbeitungsstation befördert (Pfeil P₆). In einem abschließenden Verfahrensschritt wird dann die freiliegende Lotbadoberfläche durch ein Rakel 17 von eventuellen Oxidationsrückständen gesäubert (Figur 1f), wobei die Verunreinigungen in einen Auffangbehälter 18 abgeführt werden.

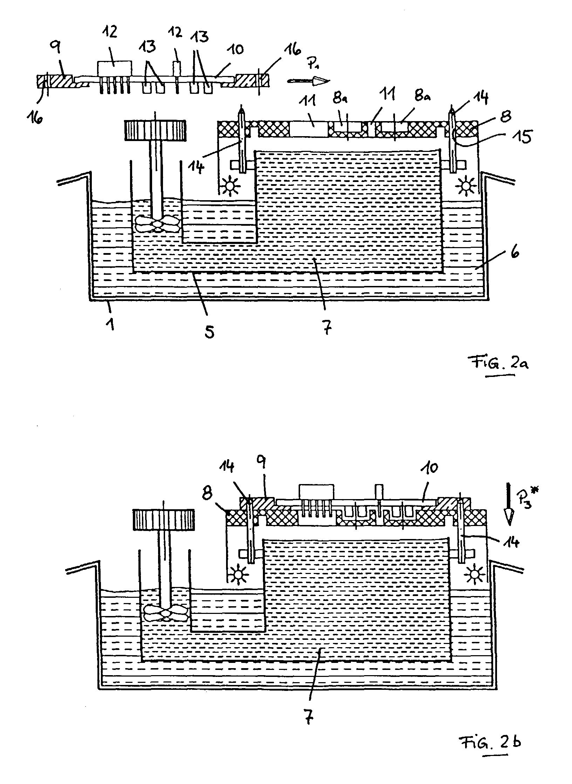

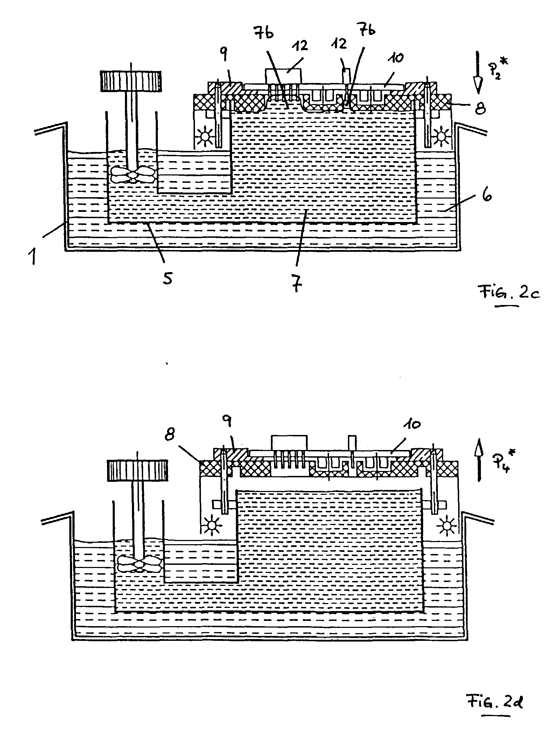

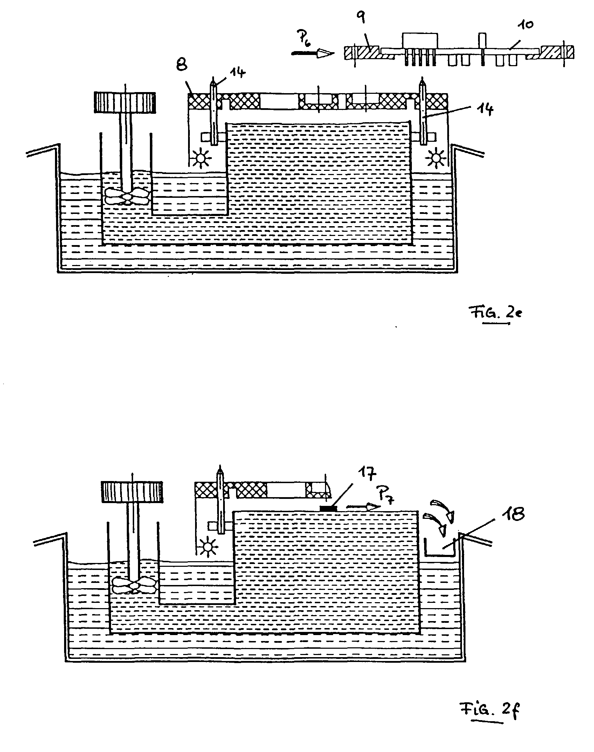

In den Figuren 2a bis 2f sind die einzelnen Phasen einer zweiten Ausgestaltung des erfindungsgemäßen Verfahrens dargestellt, wobei dieses sich von dem Verfahren gemäß den Figuren 1a bis 1f lediglich dadurch unterscheidet, daß der Aufnahmerahmen 9 mit der Leiterplatte 10 zunächst auf der Schablone 8 abgesetzt wird (Figur 2b), bevor diese Bauteile zusammen auf die Oberfläche des Lotbades abgesenkt werden (Figur 2c). Nach der Ausbildung der Lötstellen wird die Schablone 8 zusammen mit dem Aufnahmerahmen 9 und der Leiterplatte 10 von dem Lotbad 7 abgehoben (Figur 2d), woraufhin auch der Aufnahmerahmen 9 von der Schablone 8 abgehoben und zu einer weiteren Arbeitsstation geführt wird. Alle weiteren Verfahrensschritte wurden bereits im Zusammenhang mit der ersten Ausgestaltung des Verfahrens in den Figuren 1a bis 1f erläutert, so daß darauf verwiesen wird.

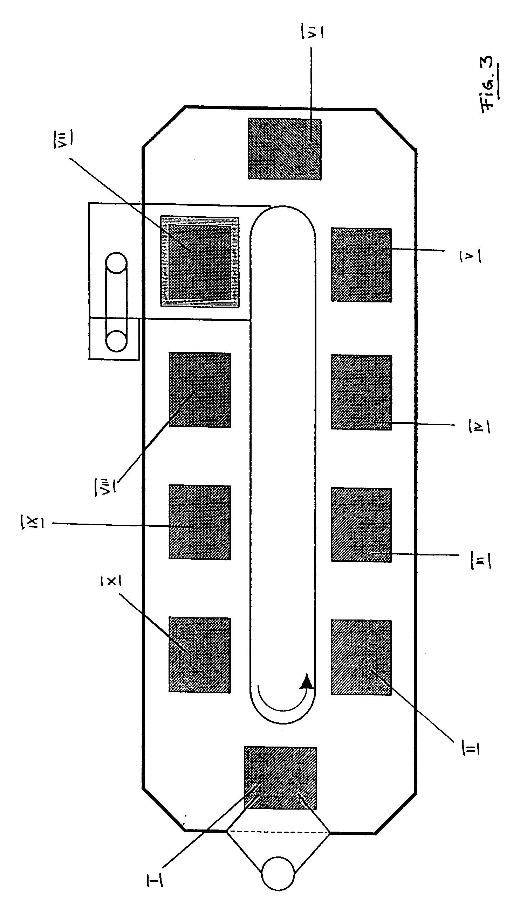

Figur 3 zeigt eine schematische Aufsicht auf eine Lötanlage, in der die einzelnen Stationen dargestellt sind. In der gemäß Figur 3 linken Station I wird die Leiterplatte manuell oder automatisch auf den Aufnahmerahmen aufgelegt. Auf diesem durchläuft sie die Lötanlage dann in Gegenuhrzeigerrichtung, wobei in der Station II ein Flußmittel aufgebracht wird. Da das Flußmittel nur in denjenigen Bereichen aufgebracht werden darf, die später auch verlötet werden, ist erfindungsgemäß vorgesehen, das Flußmittel unter Zwischenschaltung einer Sprühschablone aufzusprühen, wobei die Sprühschablone ebenfalls ein Muster von Durchbrechungen entsprechend den nachträglich auf der Leiterplatte auszubildenden Lötpunkten oder -bereichen besitzt.

Falls weitere Vorarbeiten für das Verlöten vorzusehen sind, können diese in der nächsten Station III durchgeführt werden. Bei der in Figur 5 zeigten Anlage dienen die Stationen IV, V und VI dem Vorheizen der Leiterplatte, während der eigentliche Lötvorgang in der Station VII erfolgt.

Die Stationen VIII, IX und X erlauben ein Abkühlen der Leiterplatte nach dem Lötvorgang, woraufhin die fertig verlötete Leiterplatte an der Station I wieder von dem Aufnahmerahmen entnommen wird.

## Patentansprüche

1. Verfahren zum Verlöten von weiteren elektronischen Bauelementen (12) auf einer Leiterplatte (10), die bereits verlötete Bauelemente (13) trägt, wobei die weiteren Bauelemente (12) durch die Leiterplatte (10) hindurchgesteckt werden und eine Schablone (8), die ein Muster von Durchbrechungen (11) entsprechend den nachträglich auf der Leiterplatte (10) auszubildenden Lötpunkten oder -bereichen aufweist, auf die Oberfläche (7a) des Lotbades (7) abgesenkt wird und das Lot in den Durchbrechungen (11) aufsteigt, wobei die Leiterplatte (10) mit den vormontierten weiteren Bauelementen (12) derart auf die Schablone (8) aufgesetzt wird, daß die zu verlötenden Bereiche innerhalb der Durchbrechungen (11) der Schablone (8) angeordnet sind und in das dort befindliche Lot (7b) eintauchen, und
wobei die Leiterplatte (10) und die Schablone (8) anschließend von der Oberfläche (7a) des Lotbades (7) abgehoben werden,
dadurch gekennzeichnet, daß die Schablone (8) derart auf die Oberfläche (7a) des Lotbades (7) gedrückt wird, daß das Lot in, die Durchbrechung (11) ausweicht, und daß die Schablone (8) entlang einer Führung (14) zwischen einer von der Oberfläche (7a) des Lotbades (7) abgehobenen Stellung und einer auf die Oberfläche (7a) des Lotbades (7) drückenden, abgesenkten Stellung verfahrbar ist.

2. Verfahren nach Anspruch 1, dadurch gekennzeichnet, daß die Führung von zumindest zwei Führungsstiften (14) gebildet ist.

3. Verfahren nach Anspruch 1 oder 2, dadurch gekennzeichnet, daß die Leiterplatte (10) relativ zu der Schablone (8) mittels einer Führungsvorrichtung positioniert wird.

4. Verfahren nach einem der Ansprüche 1 bis 3, dadurch gekennzeichnet, daß die Leiterplatte (10) auf einem Aufnahmerahmen (9) angeordnet wird, der relativ zur Schablone (8) geführt ist.

5. Verfahren nach Anspruch 4, dadurch gekennzeichnet, daß die Führungsstifte (14) den Aufnahmerahmen (9) relativ zur Schablone (8) führen.

6. Verfahren nach einem der Ansprüche 1 bis 5, dadurch gekennzeichnet, daß die Schablone (8) auswechselbar ist.

7. Verfahren nach einem der Ansprüche 1 bis 6 , dadurch gekennzeichnet, daß die Leiterplatte (10) auf die Schablone (8) aufgesetzt wird, nachdem diese auf die Oberfläche (7a) des Lotbades (7) abgesenkt ist.

8. Verfahren nach einem dem Ansprüche 1 bis 6 dadurch gekennzeichnet, daß die Leiterplatte (10) zunächst auf die Schablone (8) aufgesetzt und anschließend zusammen mit dieser auf die Oberfläche (7a) des Lotbades (7) absenkt wird.

9. Verfahren nach einem der Ansprüche 1 bis 8, dadurch gekennzeichnet, daß die Oberfläche (7a) des Lotbades (7) nach dem Abheben der Schablone (8) gesäubert wird.

10. Verfahren nach einem der Ansprüche 1 bis 9, dadurch gekennzeichnet, daß die Schablone (8) auf ihrer der Oberfläche (7a) des Lotbades (7) abgewandten Seite Ausnehmungen (8a) aufweist, in denen die bereits auf der Leiterplatte (10) montierten Bauelemente (13) während des Lötvorgangs aufgenommen werden.

11. Verfahren nach einem der Ansprüche 1 bis 10, wobei auf die zu verlötenden Punkte bzw. Bereiche der Leiterplatte (10) in einem vorhergehenden Arbeitsschritt ein Flußmittel aufgebracht wird, dadurch gekennzeichnet, daß das Flußmittel unter Zwischenschaltung einer Sprühschablone aufgespritzt wird, die ein Muster von Durchbrechungen entsprechend den nachträglich auf der Leiterplatte auszubildenden Lötpunkten oder -bereichen aufweist.

12. Verfahren nach Anspruch 11, dadurch gekennzeichnet, daß die Leiterplatte (10) oberhalb der Sprühschablone positioniert und das Flußmittel von unten aufgesprüht wird.

13. Verfahren nach einem der Ansprüche 1 bis 12, dadurch gekennzeichnet, daß die Leiterplatte (10) vorgewärmt wird.

## Claims

1. Method for soldering further electronic components (12) to a printed circuit board (10), which already carries soldered components (13), in which the further components (12) are passed through the printed circuit board (10) and a template (8), which has a pattern of holes (11) corresponding to the solder points or areas to be subsequently formed on the printed circuit board (10) is lowered into the surface (7a) of the solder bath (7) and the solder rises into the holes (11), the printed circuit board (10) with the preassembled, further components (12) is so placed on the template (8) that the areas to be soldered are located within the holes (11) in the template (8) and are immersed in the solder (7b) located there and in which the printed circuit board (10) and template (8) are subsequently raised from the surface (7a) of the solder bath (7), characterized in that the template (8) is pressed onto the surface (7a) of the solder bath (7) in such a way that the solder escapes into the hole (11) and that the template (8) is movable along a guide (14) between a position raised from the surface (7a) of the solder bath (7) and a lowered position pressing onto the surface (7a) of the solder bath (7).

2. Method according to claim 1, characterized in that the guide is formed by at least two guide pins (14).

3. Method according to claim 1 or 2, characterized in that the printed circuit board (10) is positioned relative to the template (8) by means of a guide mechanism.

4. Method according to one of the claims 1 to 3, characterized in that the printed circuit board (10) is placed on a mounting frame (9) guided relative to the template (8).

5. Method according to claim 4, characterized in that the guide pins (14) guide the mounting frame (9) relative to the template (8).

6. Method according to one of the claims 1 to 5, characterized in that the template (8) is interchangeable.

7. Method according to one of the claims 1 to 6, characterized in that the printed circuit board (10) is placed on the template (8), after the latter has been lowered onto the surface (7a) of the solder bath (7).

8. Method according to one of the claims 1 to 6, characterized in that the printed circuit board (10) is initially placed on the template (8) and is subsequently lowered together with the latter onto the surface (7a) of the solder bath (7).

9. Method according to one of the claims 1 to 8, characterized in that the surface (7a) of the solder bath (7) is cleaned following the raising of the template (8).

10. Method according to one of the claims 1 to 9, characterized in that on its side remote from the surface (7a) of the solder bath (7), the template (8) has recesses (8a), in which are received during the soldering process the components (13) already mounted on the printed circuit board (10).

11. Method according to one of the claims 1 to 10, in which in a preceding working step, a flux is applied to the points or areas of the printed circuit board (10) to be soldered, characterized in that the flux is sprayed on, accompanied by the interposing of a spraying template having a pattern of holes corresponding to the solder points or areas to be subsequently formed on the printed circuit board.

12. Method according to claim 11, characterized in that the printed circuit board (10) is positioned above the spraying template and the flux is sprayed on from below.

13. Method according to one of the claims 1 to 12, characterized in that the printed circuit board (10) is preheated.

## Revendications

1. Procédé de brasage de composants (12) électroniques supplémentaires sur une carte de circuits imprimés (10) portant déjà des composants (13) brasés, dans lequel les composants (12) supplémentaires sont enfichés à travers la carte de circuits imprimés (10) et dans lequel un gabarit (8), présentant un modèle de répartition d'ouvertures (11) correspondant aux points ou aux zones de brasage à réaliser ensuite sur la carte de circuits imprimés (10), est abaissé sur la surface (7a) du bain de brasage (7), l'apport de brasage montant dans les ouvertures (11), procédé dans lequel la carte de circuits imprimés (10) comprenant les composants (12) supplémentaires prémontés est posée de manière telle sur le gabarit (8) que les zones à braser sont disposées à l'intérieur des ouvertures (11) du gabarit (8) et plongent dans l'apport de brasage (7b) qu'elles contiennent, et dans lequel la carte de circuits imprimés (10) et le gabarit (8) sont ensuite enlevés de la surface (7a) du bain de brasage (7), caractérisé en ce que le gabarit (8) est appliqué de façon telle sur la surface (7a) du bain de brasage (7) que l'apport de brasage pénètre dans les ouvertures (11), et en ce que le gabarit (8) peut être déplacé le long d'un guide (14) entre une position dans laquelle il est dégagé de la surface (87a) du bain de brasage (7) et une position abaissée appuyant sur la surface (7a) du bain de brasage (7).

2. Procédé selon la revendication 1, caractérisé en ce que le guide est constitué par au moins deux goupilles de guidage (14).

3. Procédé selon la revendication 1 ou 2, caractérisé en ce que la carte de circuits imprimés (10) est positionnée par rapport au gabarit (8) au moyen d'un dispositif de guidage.

4. Procédé selon l'une quelconque des revendications 1 à 3, caractérisé en ce que la carte de circuits imprimés (10) est disposée sur un cadre de réception (9) guidé par rapport au gabarit (8).

5. Procédé selon la revendication 4, caractérisé en ce que les goupilles de guidage (14) guident le cadre de réception (9) par rapport au gabarit (8).

6. Procédé selon l'une quelconque des revendications 1 à 5, caractérisé en ce que le gabarit (8) est interchangeable.

7. Procédé selon l'une quelconque des revendications 1 à 6, caractérisé en ce que la carte de circuits imprimés (10) est posée sur le gabarit (8) après avoir abaissé celui-ci sur la surface (7a) du bain de brasage (7).

8. Procédé selon l'une quelconque des revendications 1 à 6, caractérisé en ce que la carte de circuits imprimés (10) est d'abord posée sur le gabarit (8) et est ensuite abaissée avec celui-ci sur la surface (7a) du bain de brasage (7).

9. Procédé selon l'une quelconque des revendications 1 à 8, caractérisé en ce que l'on nettoie la surface (7a) du bain de brasage (7) après avoir enlevé le gabarit.

10. Procédé selon l'une quelconque des revendications 1 à 9, caractérisé en ce que le gabarit (8) présente sur sa face opposée à la surface (7a) du bain de brasage (7) des ouvertures (8a), qui reçoivent les composants (13) déjà montés sur la carte de circuits imprimés (10) durant l'opération de brasage.

11. Procédé selon l'une quelconque des revendications 1 à 10, dans lequel on applique, au cours d'une étape antérieure, un fondant sur les points ou les zones de la carte de circuits imprimés (10) à braser, caractérisé en ce que le fondant est pulvérisé en intercalant un gabarit de pulvérisation présentant un modèle d'ouvertures correspondant aux points ou zones de brasage à réaliser ensuite sur la carte de circuits imprimés.

12. Procédé selon la revendication 11, caractérisé en ce que la carte de circuits imprimés (10) est positionnée au-dessus du gabarit de pulvérisation et en ce que le fondant est pulvérisé par le bas.

13. Procédé selon l'une quelconque des revendications 1 à 12, caractérisé en ce que l'on préchauffe la carte de circuits imprimés.
